# EUROPÄISCHE PATENTANMELDUNG

(11) **EP 0 818 947 A1**
(43) Veröffentlichungstag der Anmeldung: **14.01.1998**
(21) Anmeldenummer: 97109433.9
(22) Anmeldetag: 11.06.1997
(51) Int. Cl.: H05K 7/14, H05K 3/34

(54) **Halter für Leiterplatten**

(30) Priorität: 10.07.1996 DE 19627726
(71) Anmelder: ROBERT BOSCH GMBH, 70442 Stuttgart (DE)
(72) Erfinder: Deptula, Piotr, 72116 Mössingen (DE); Haussmann, Martin, 70794 Filderstadt (DE)

(57) **Zusammenfassung**

Um einen Abstandshalter für Leiterplatten mit einem Körper aus Isoliermaterial, der auf der Leiterplatte befestigbar ist, dahingehend zu verbessern, daß er mit möglichst geringem Montageaufwand auf der Leiterplatte zu befestigen ist, wird vorgeschlagen, daß der Körper auf seiner der Leiterplatte zugewandten Seite wenigstens partiell derart mit wenigstens einer elektrisch leitenden Schicht beschichtet ist, daß sie als oberflächenmontierbare Komponente (SMD) auf der Leiterplatte befestigbar ist.

## Beschreibung

### Stand der Technik

Die Erfindung betrifft einen Astandshalter für Leiterplatten mit einem Körper aus Isoliermaterial, der auf der Leiterplatte befestigbar ist.

Bei elektronischen Steuergeräten, die auf Leiterplatten basieren, sind die Abstände zwischen den einzelnen Komponenten sehr klein. Derartige Steuergeräte werden beispielsweise in Kraftfahrzeugen eingesetzt. Hier besteht die Gefahr, daß durch das Rütteln während des Fahrens ein Kurzschluß zwischen der Leiterplatte und dem zumeist metallischen Gehäuse entsteht. Um die Gefahr eines derartigen Kurzschlusses zwischen der Leiterplatte und dem Gehäuse zu beseitigen, können einrastbare Abstandshalter zum Einsatz oder es werden Isolierplatten oder sogenannte Moosgummis zwischen der Leiterplatte und dem Gehäuse eingesetzt.

Nachteilig bei derartigen Isolierplatten und Abstandshaltern ist, daß sie in aufwendiger Weise und nach der Bestückung der Leiterplatte montiert werden müssen. Dies erfordert einen zusätzlichen Montageaufwand und verteuert somit das gesamte elektronische Steuergerät.

Aus der DE-41 29 990 A1 sind Schaltungsfüße für oberflächenmontierbare Komponenten (SMD) zur Anwendung in der Oberflächenmontagetechnik der Elektronik bekannt. Diese Schaltungsfüße sind zwar zusammen mit der Bestückung der Leiterplatte auf einfache Weise und ohne großen Montageaufwand direkt auf der Leiterplatte - beispielsweise durch Löten - befestigbar, sie können jedoch nicht als Abstandshalter verwendet werden, da sie aus Metall bestehen und insoweit einen Kurzschluß zwischen Leiterbahnen und Bauelementen der Leiterplatte und dem Gehäuse nicht verhindern können.

Der Erfindung liegt daher die Aufgabe zugrunde, einen Abstandshalter der gattungsgemäßen Art derart zu verbessern, daß dieser zum einen leicht und ohne großen Montageaufwand auf der Leiterplatte montierbar ist und zum anderen wirkungsvoll Kurzschlüsse zwischen der Leiterplatte und dem Gehäuse eines elektronischen Steuergeräts verhindert.

### Vorteile der Erfindung

Diese Aufgabe wird bei einem Abstandshalter für Leiterplatten der eingangs beschriebenen Art erfindungsgemäß dadurch gelöst, daß der Körper auf seiner der Leiterplatte zugewandten Seite partiell derart mit wenigstens einer elektrisch leitenden Schicht beschichtet ist, daß er als oberflächenmontierbare Komponente (SMD) auf der Leiterplatte befestigbar ist.

Die partielle Beschichtung des Abstandshalters mit wenigstens einer elektrisch leitenden Schicht derart, daß der Abstandshalter als oberflächenmontierbare Komponente auf der Leiterplatte befestigbar ist, hat den besonders großen Vorteil, daß der Abstandshalter auf einfache Weise, nämlich nach Befestigung mit einem SMD-Kleber, auf der Lötwelle gelötet werden kann. Dabei haftet der Lötzinn nur auf seiner unteren, der Leiterplatte zugewandten Seite, die wenigstens partiell mit wenigstens einer elektrisch leitenden Schicht beschichtet ist, wohingegen der Lötzinn an den nicht beschichteten Stellen des Abstandshalters nicht haftet. Hierdurch kann ein aus einem Isoliermaterial bestehender Abstandshalter auf besonders einfache Weise zusammen mit den anderen SMD-Komponenten bei der Bestückung der Leiterplatte auf der Leiterplatte befestigt werden.

Rein prinzipiell könnte der Körper des Abstandshalters aus den unterschiedlichsten Isoliermaterialien hergestellt sein.

Vorzugsweise ist der Körper jedoch ein Kunststoff-Spritzgußteil, das besonders einfach und kostengünstig herzustellen ist.

Vorteilhafterweise besteht der Körper aus einem thermothropen Kunststoff (z.B. LCP, oder Ultem von GE-Plastics u.dgl.).

Hinsichtlich der Ausbildung der wenigstens einen elektrisch leitenden Schicht sind die unterschiedlichsten Ausführungen denkbar. Eine besonders vorteilhafte Ausführungsform sieht jedoch vor, daß die wenigstens eine elektrische Schicht eine Kupferschicht und eine diese überdeckende Gold- oder Lötzinn-Schicht umfaßt. Durch diese Gold- oder Lötzinn-Schicht kann der Abstandshalter besonders einfach auf die Leiterplatte gelötet werden.

Vorzugsweise beträgt die Dicke der Kupferschicht zwischen 0,90 und 1,50 µm, insbesondere 1,20 µm, wohingegen die Schichtdicke der Lötzinn-Schicht vorzugsweise zwischen 2,00 und 2,30 µm, insbesondere 2,15 µm, beträgt.

Um insbesondere beim Rütteln der Leiterplatte in einem Gehäuse eines elektronischen Steuergeräts die Geräuschkulisse möglichst gering zu halten, weist der Abstandshalter auf seiner der Leiterplatte abgewandten Seite wenigstens eine, vorzugsweise zwei, Geräuschdämpfungslaschen auf. Mit diesen Geräuschdämpfungslaschen stützt sich der Abstandshalter federnd an einer Gehäusewand ab, wodurch Geräusche beim Rütteln der Leiterplatte in dem Gehäuse minimiert werden.

### Zeichnung

Weitere Merkmale und Vorteile der Erfindung sind Gegenstand der nachfolgenden Beschreibung sowie der zeichnerischen Darstellung eines Ausführungsbeispiels.

In der Zeichnung zeigen:
- Fig. 1a, b, c: eine Draufsicht und zwei Seitenansichten von unterschiedlichen Seiten eines erfindungsgemäßen Abstandshalters für Leiterplatten und
- Fig. 2: perspektivisch schematisch einen erfindungsgemäßen Abstandshalter für Leiterplatten.

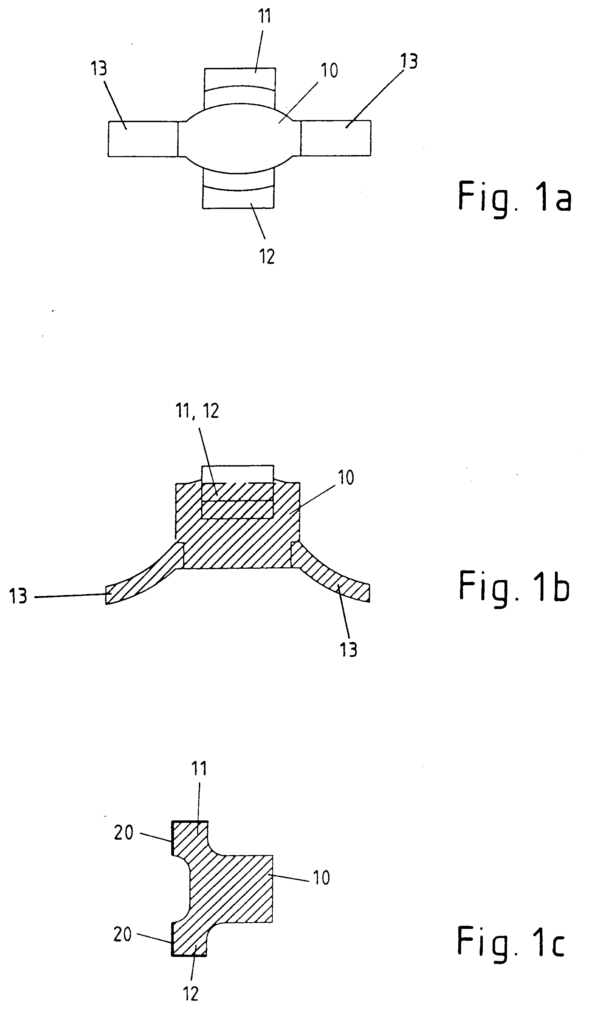

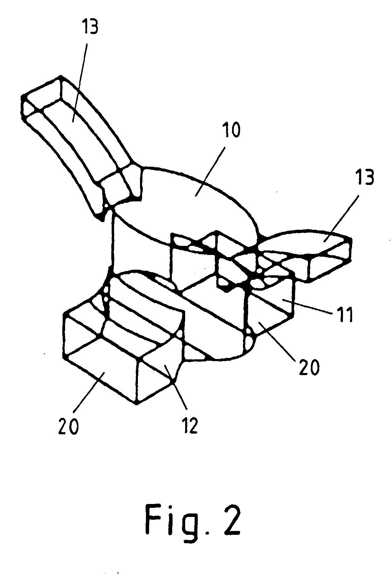

Ein Ausführungsbeispiel eines Abstandshalters für Leiterplatten, dargestellt in Fig. 1 und Fig. 2, umfaßt einen als Ganzen mit 10 bezeichneten Körper aus Isoliermaterial, der auf einer (nicht dargestellten) Leiterplatte befestigbar ist.

Der Körper 10 weist auf seiner der Leiterplatte zugewandten Seite zwei Füße 11, 12 auf. Diese Füße 11, 12 sind auf ihrer der Leiterplatte zugewandten Seite mit einer elektrisch leitenden Schicht 20 beschichtet. Die elektrisch leitende Schicht 20 umfaßt eine Kupferschicht von einer Dicke von etwa 1,20 µm und eine diese überdeckende Gold- oder Lötzinnschicht. Die Lötzinnschicht, beispielsweise Lötzinn mit einer Zusammensetzung aus SnPb90/10 weist vorzugsweise eine Dicke von 2,15 µm auf.

An seiner der Leiterplatte abgewandten und der (nicht dargestellten) Gehäusewand zugewandten Seite weist der Körper 10 Geräuschdämpfungslaschen 13 auf, mit denen sich der Abstandshalter an der Innenwand eines (nicht dargestellten) Gehäuses eines elektronischen Steuergeräts abstützt, während er auf der Leiterplatte befestigt ist. Auf diese Weise wird die Leiterplatte nicht nur gegenüber dem Gehäuse durch Abstandsbildung isoliert, sondern diese auch rüttel- und schüttelfest in dem Gehäuse fixiert und dabei beim Rütteln oder Schütteln die Geräuschkulisse minimiert.

Der große Vorteil des obenbeschriebenen Abstandshalters besteht darin, daß er während des Bestückens der Leiterplatte auf der Leiterplatte angeordnet werden kann. Hierzu wird der der Leiterplatte zugewandte, mit der elektrisch leitenden Schicht 20 beschichtete Teil des Abstandshalters zunächst mit einem SMD-Kleber auf der Leiterplatte befestigt und kann daraufhin auf der Lötwelle gelötet werden. Durch diesen Lötprozeß ist der Abstandshalter zum einen fest mit der Leiterplatte verbunden, zum anderen sind zur Befestigung des Abstandshalters und damit zur Isolierung der Leiterplatte gegenüber dem zumeist metallischen Gehäuse eines elektronischen Steuergeräts keine zusätzlichen Montageschritte erforderlich, wodurch sich der Herstellungsprozeß des gesamten elektronischen Steuergeräts vereinfacht und damit auch verbilligt.

## Patentansprüche

1. Abstandshalter für Leiterplatten mit einem Körper aus Isoliermaterial, der auf der Leiterplatte befestigbar ist, dadurch gekennzeichnet, daß der Körper (10) auf seiner der Leiterplatte zugewandten Seite wenigstens partiell derart mit wenigstens einer elektrisch leitenden Schicht (20) beschichtet ist, daß er als oberflächenmontierbare Komponente (SMD) auf der Leiterplatte befestigbar ist.

2. Abstandshalter nach Anspruch 1, dadurch gekennzeichnet, daß der Körper (10) ein Kunststoff-Spritzgußteil ist.

3. Abstandshalter nach Anspruch 1 oder 2, dadurch gekennzeichnet, daß der Körper (10) aus einem thermothropen Kunststoff (LCP) besteht.

4. Abstandshalter nach einem der voranstehenden Ansprüche, dadurch gekennzeichnet, daß die wenigstens eine elektrisch leitende Schicht (20) eine Kupferschicht und eine diese überdeckende Gold- oder Lötzinn-Schicht umfaßt.

5. Abstandshalter nach Anspruch 4, dadurch gekennzeichnet, daß die Dicke der Kupferschicht zwischen 0,90 und 1,50 µm, insbesondere 1,20 µm, beträgt.

6. Abstandshalter nach Anspruch 4 oder 5, dadurch gekennzeichnet, daß die Schichtdicke der Lötzinn-Schicht zwischen 2,00 und 2,30 µm, insbesondere 2,15 µm, beträgt.

7. Abstandshalter nach Anspruch 6, dadurch gekennzeichnet, daß das Lötzinn zu 90 % aus Zinn und zu 10 % aus Blei besteht.

8. Abstandshalter nach einem der voranstehenden Ansprüche, dadurch gekennzeichnet, daß der Körper (10) auf seiner der Leiterplatte abgewandten Seite wenigstens eine, vorzugsweise zwei Geräuschdämpfungslaschen (13) aufweist.
